# EUROPEAN PATENT SPECIFICATION

(11) **EP 0 324 550 B1**
(45) Date of publication and mention of the grant of the patent: **06.10.1993**
(21) Application number: 89300110.7
(22) Date of filing: 06.01.1989
(51) Int. Cl.: G02F 1/133, H01L 31/02

(54) **Thin film pattern structure**
Dünnschichtmusterstruktur
Structure de motif en couche mince

(30) Priority: 06.01.1988 JP 1576/88; 06.01.1988 JP 1577/88; 06.01.1988 JP 1578/88
(43) Date of publication of application: 19.07.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo (JP)
(74) Representative: Milhench, Howard Leslie

(56) References cited:
- EP-A- 0 111 402
- EP-A- 0 225 470
- FR-A- 2 254 081
- GB-A- 2 012 446

## Description

### BACKGROUND OF THE INVENTION

The present invention relates to a thin film pattern structure and more particularly relates to a thin film pattern structure fabricated on a glass substrate by laser scribing.

Photolithography is a well known technique for producing patterns in thin films formed on substrates. This technique is convenient and advantageous, having regard to the desirability of removing portions of the thin film to be processed without causing damage to the underlying surface. However, a somewhat large number of steps is necessary for completing the patterning procedure in accordance with this method. Namely after forming the thin film to be treated on a substrate, a photoresist film is formed and patterned, then the thin film is subjected to the action of an etchant with the patterned photoresist film used as a mask, and then the photoresist film is removed.

Laser scribing techniques are well known in the art and provide a low cost patterning method capable of operation at high speed. The YAG laser (IR light, 1.06 µm) is a representative laser which has been generally used for this purpose. Since the optical energy of this laser is only 1.23 eV, however, tin oxide, indium oxide (or ITO), Zn0 and other materials having optical energy gaps of about 3 to 4 eV are not effectively processed by a YAG laser. Since transparent conductive oxide (CTO) films are generally made of this class of materials, the inability of YAG lasers to scribe such materials is a significant disadvantage.

The Applicant has proposed the use of excimer lasers in order to emit pulsed laser beams for performing the laser scribing of transparent conductive films. The wavelength of the excimer laser beams is not greater than 400 nm, equivalent to photon energies higher than 3.1 eV. This laser scribing method, however, has a shortcoming. When portions of a transparent conductive film formed over a sodium glass substrate with an ion blocking film therebetween are removed in order to produce electrode patterns thereon, the ion blocking film and the glass substrate are also partially eliminated and in consequence the surface of the glass substrate is exposed. In the case where such substrates are used in liquid crystal device manufacture, this can give rise to the problem that eventually the liquid crystal material contained in the device may be contaminated by sodium ions introduced from the glass substrate. Furthermore, the laser scribing can make the upper surface of the scribed device uneven in that residue from the scribing operation can remain in and around the edges of the removed portions to a depth of as much as 0.5 to 1 µm. This unevenness is undesirable, not only in regard to the manufacture of liquid crystal devices but also in regard to the manufacture of other electric devices formed by a laminating process. The uneven surface might possibly be the cause of electrical shorting between different levels of the laminate and might cause disconnection of electrical patterns superimposed thereon.

### SUMMARY OF THE INVENTION

According to the present invention there is provided a method of forming a pattern in a thin electrically-conductive film formed on a glass substrate with an ion blocking film formed therebetween, said method comprising:
forming the ion blocking film on the glass substrate and then forming the electrically-conductive film on top of the ion blocking film; and
laser scribing the electrically-conductive film so as to form the desired pattern;
the method being characterized in that the laser scribing is effected such that the pattern is formed additionally in the ion blocking film underlying the electrically-conductive film and portions of the glass substrate are exposed, and a second ion blocking film is subsequently provided overlying at least the portions of the substrate that were exposed by the laser scribing of the electrically-conductive film and the underlying ion blocking film.

As will be explained more fully hereinafter, by laser scribing both the electrically-conductive film and the underlying ion blocking film and then replacing the removed parts of the ion blocking film by provision of an overlying ion blocking layer, the present invention enables laser scribing to be employed for the formation of such conductive patterns on glass substrates without risk of contaminants leaking from the substrate.

The provision of an ion blocking film overlying a patterned electrically-conductive film is disclosed in EP-A-0225470, but there is no disclosure in EP-A-0225470 of the patterning of the conductive film by means of laser scribing and EP-A-0225470 is not concerned with and does not address the problems that arise when laser scribing is used.

The above and further features of the invention are set forth with particularity in the appended claims and, will best be understood from consideration of the following detailed description given with reference to the accompanying drawings.

### DESCRIPTION OF THE DRAWINGS

Fig. 1 is a schematic diagram showing an exemplary laser scribing assembly for use in laser patterning in accordance with the present invention;
Figs. 2(A) to 2(D) are explanatory views showing how the laser beam cross-section is shaped in the apparatus of Fig. 1; and
Figs. 3(A) to 3(D) are cross-sectional views showing the process for fabrication of a thin film pattern in accordance with the present invention.

### DETAILED DESCRIPTION OF THE EMBODIMENTS

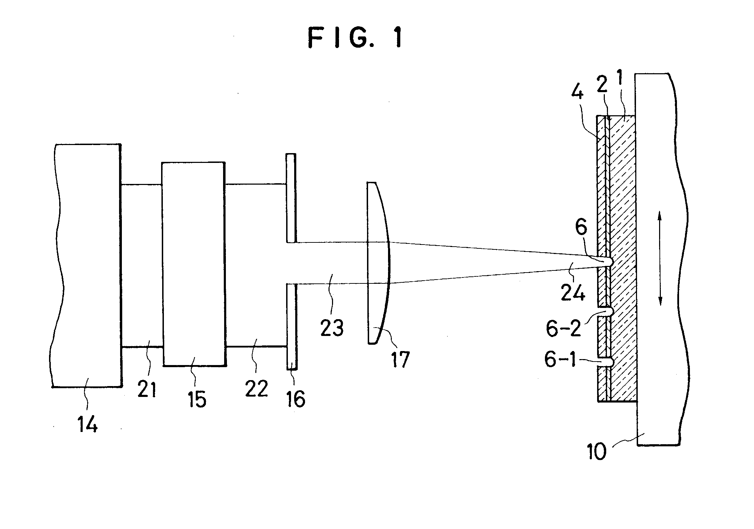

Referring now to Fig. 1, a laser scribing assembly is shown in accordance with one exemplary embodiment of the present invention. The laser scribing assembly is comprised of an excimer laser 14 having a wavelength no greater than 400nm (for example a KrF excimer laser having a wavelength = 248nm, Eg = 5.0 eV, efficiency = 3% and output energy = 350 mj), a beam expander 15, a mask 16, a convex cylindrical lens 17 made of synthetic quartz and a substrate holder 10. The substrate holder 10 is adapted to move in the vertical direction as viewed in the illustration in order to change the position of a soda-lime glass substrate 1 mounted thereon. Formed on the substrate 1 are an ion blocking film 2 of 10 to 150 nm, e.g. 20 nm, thickness made of silicon oxide containing very little amounts of phosphorus, sodium and boron, and a transparent conductive film of 100 to 300 nm thickness made of ITO, tin oxide, zinc oxide or of a laminate thereof. The transparent conductive film 4 may be provided with a chromium or molybdenum thin film coating. Depending on the intended application, an insulating or semiconductor film may be formed under or over the conductive film as desired.

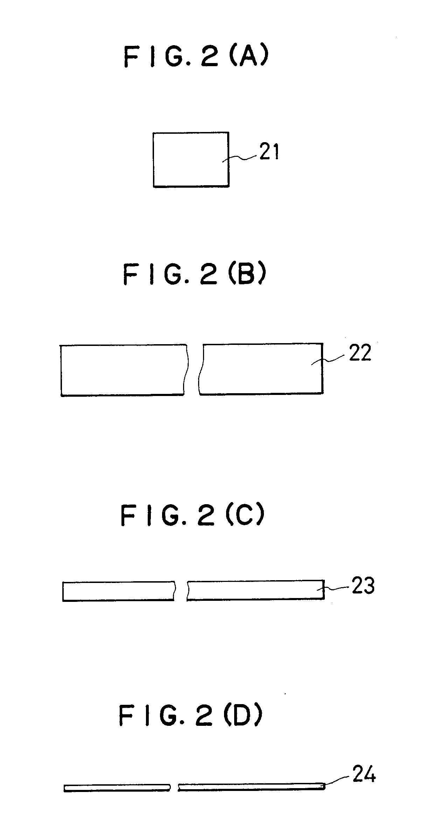

As illustrated in Fig. 2(A), the laser beam 21 emitted from the excimer laser 14 has a rectangular cross-section of 16 mm height and 20 mm width. This laser beam 21 is expanded by beam expander 15 to have a width of 300 mm, as illustrated in Fig. 2(B), while its height is unchanged. After being expanded, the energy density of the beam becomes 5.6 x 10⁻²mj/mm². The expanded beam 22 is then collimated by means of the mask 16 and the beam height is reduced to 2 mm as illustrated in Fig. 2(C). The collimation of the expanded laser beam is effected for the purpose of reducing aberration by the following lens 17. The resulting flat laser beam 23 is focussed onto the surface of the substrate 1 by means of the lens 17 as illustrated in Fig. 1 and impinges on the substrate surface with the cross-section shown in Fig. 2(D). The height of the laser beam at the surface of the substrate 1 might for example be 10 µm. In practice, the grooves to be formed on the substrate may have widths ranging from 2 microns to 200 µm, e.g. 50 µm, 20 µm, 10 µm, 5 µm and 3 µm, depending upon the intended application.

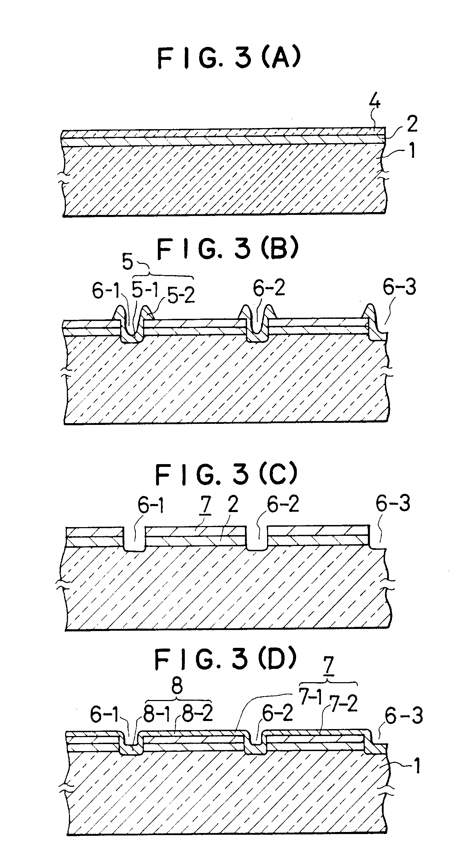

The laser beam is repeatedly projected onto the substrate 1 in the form of pulses. The pulse duration may be 20 nano seconds and the frequency may be 1-100 Hz, for example 10 Hz. By this means, grooves 6-1, 6-2,... are formed as illustrated in Fig. 3(B). The distance between adjacent grooves may be 2 µm for example. Residue 5 is left around and inside of the grooves as illustrated in Fig. 3(B). This residue may be selectively removed by use of an acid etchant, for example a hydrofluoric acid (diluted by water at 1/10) or a fluoride solution mixture such as an acidic ammonia fluoride, followed by ultrasonic cleaning with acetone and pure water as illustrated in Fig. 3(C). In this structure, however, the upper portions of the glass substrate (0.3-1.0 µm depth) just under the grooves are also removed and the surface of the glass substrate is exposed through the grooves.

If a structure as shown in Fig. 3(C) were to be used in the manufacture of a liquid crystal device, the liquid crystal material, which has to be of high purity, would be contaminated by sodium ions from the soda-lime substrate when subjected to long term use. Also, if it were to be used as a substrate for image sensors, solar cells and the like, amorphous semiconductor films utilized in such devices would be contaminated by sodium ions, resulting in degradation of the photoelectric conversion ability of the device and the modification of the semiconductor to n-type.

In order to avoid such undesirable contamination by sodium ions, the invention proposes that a second ion blocking film 8 is formed on the substrate 1 over the grooves. The formation of the second blocking film may be carried out by coating the grooved structure with an organic resin such as polyimide or with an inorganic substance such as silicon oxide. Preferably, the second blocking film is applied to the substrate in precursor fluid form, such as in a non-polymer state or in the form of an organic silicon liquid compound such as a silazane. A spinner may be used for applying such precursor coating, or alternatively screen press printing techniques, spraying techniques or other coating methods may be used instead. The thickness of the precursor film may be 5 to 250 nm, for example the thickness may be 30 nm on the conductive film and 50 nm in the grooves. The precursor film is then thermally cured. For example, in the case of a polyimide solution, the film may be cured by being heated at 230°C for two hours. In the case of an organic silicon liquid compound, the film may be transformed into a blocking film of solid state silicon oxide by thermal annealing.

It is to be noted that, in accordance with the above mentioned coating methods, the thickness of the second blocking film where it is provided in the grooves is desirably greater than that over the transparent conductive film 4. For instance, when the second blocking film is formed to a thickness of 5 to 30 nm on the conductive film, the thickness of the second blocking film at the bottom of the grooves might be 10 to 60 nm. Because of this increased thickness within the grooves, ion drift through the second blocking film is effectively prevented. Ideally, it is desirable to completely fill the grooves in order to make the upper surface flat. In this regard, the use of liquid precursors is preferred. Particularly, in order to fill narrow grooves, high surface tension is advantageous.

The second blocking film when made of organic material may additionally serve as an orientation control film when a liquid crystal display is constructed with this structure, in which case rubbing treatment is given to the surface of the film. In accordance with experimental results obtained with such a display, the contrast of the displayed image was measured to be 20 and was only a little degraded even after use for 1000 hours at 50°C. Current leakage was examined by applying a direct voltage of 50 V across each groove. This examination was carried out across 100 grooves each 30 cm long and 10 µm wide, and it was found that all the leakage currents were within the range of 1 x 10⁻⁹ A to 2 x 10⁻⁹ A.

While several embodiments of the invention have been specifically described, it is to be appreciated that the present invention is not limited to the particular examples described and that modifications and variations can be made without departure from the scope of the invention as defined by the appended claims. Examples of such alterations are described hereinafter.

Insulating films constituting a color filter may be integrally formed under or over the transparent conductive film.

Although the conductive film is described in the foregoing as being made of a transparent conductive material such as ITO, Si0₂ or Zn0, a thin film of a metal such as chromium or molybdenum can be used in the same manner.

An image sensor can be constructed by superimposing an amorphous silicon semiconductor film on the transparent conductive film and covering the semiconductor film by an opposed electrode arrangement.

Although in accordance with the preferred embodiment, the grooves are narrow as compared with the remaining transparent conductive film, narrow strips of 20 µm width may be left between removed portions of 400 µm width by making use of a train of pulses which are projected sequentially while the substrate is gradually slightly moved.

## Claims

1. A method of forming a pattern in a thin electrically-conductive film (4) formed on a glass substrate (1) with an ion blocking film (2) formed therebetween, said method comprising:
forming the ion blocking film (2) on the glass substrate (1) and then forming the electrically-conductive film (4) on top of the ion blocking film (2); and
laser scribing the electrically-conductive film (4) so as to form the desired pattern;
the method being characterized in that the laser scribing is effected such that the pattern is formed additionally in the ion blocking film (2) underlying the electrically-conductive film (4) and portions of the glass substrate (1) are exposed, and a second ion blocking film (8) is subsequently provided overlying at least the portions of the substrate (1) that were exposed by the laser scribing of the electrically-conductive film (4) and the underlying ion blocking film (2).

2. A method as claimed in claim 1 wherein the second ion blocking film (8) is formed so as to overlie the entire substrate surface.

3. A method as claimed in claim 1 or 2 wherein the second ion blocking film (8) is formed by applying a liquid precursor material to the surface of the substrate (1) that is coated with the electrically-conductive film (4) such that the liquid precursor material enters into the grooves (6) formed by the laser scribing, and thereafter curing the liquid precursor material so as to form the second ion blocking film (8).

4. A method as claimed in any of the preceding claims wherein residues (5) deposited on the surface of the substrate (1) and its overlying electrically-conductive film (4) as a result of the laser scribing are removed before the second ion blocking film (8) is formed.

5. A method as claimed in claim 4 wherein the residues (5) are removed by use of an etchant.

6. A method as claimed in any of the preceding claims wherein the laser scribing is carried out with an excimer laser.

7. A method as claimed in claim 6 wherein the wavelength of the laser radiation is no greater than 400nm.

8. A method as claimed in any preceding claim wherein the electrically-conductive film (4) is formed of an electrically-conductive transparent material.

9. A method as claimed in claim 8 wherein the electrically-conductive transparent material comprises tin oxide, indium oxide, zinc oxide or ITO.

10. A method as claimed in any of the preceding claims wherein the electrically-conductive film (4) comprises a thin film of chromium or molybdenum.

11. A method as claimed in any of the preceding claims wherein the second ion blocking film (8) is formed of an organic material adapted to serve as an orientation control film in a liquid crystal display.

12. A method as claimed in any of the preceding claims wherein the substrate (1) is to be used in a liquid crystal device and the laser scribed patterns define electrode regions of the liquid crystal device.

13. A method as claimed in any of the preceding claims wherein the substrate is made of a soda-lime glass.

14. An electro-optical device comprising a liquid crystal device, or an image sensor incorporating a glass substrate having a laser scribed pattern formed in a thin electrically-conductive film provided thereon, and wherein the pattern is formed in the electrically-conductive film by a method as claimed in any of the preceding claims.

## Patentansprüche

1. Verfahren zum Erzeugen eines Musters in einer auf einem Glassubstrat (1) ausgebildeten dünnen elektrisch leitfähigen Schicht (4) mit einer dazwischenliegenden Ionensperrschicht (2), umfassend:
Ausbilden der Ionensperrschicht (2) auf dem Glassubstrat (1) und anschließendes Ausbilden der elektrisch leitfähigen Schicht (4) auf der Ionensperrschicht (2), und
Ritzen der elektrisch leitfähigen Schicht (4) mittels Laser zur Erzeugung des gewünschten Musters,
dadurch gekennzeichnet, daß das Ritzen mittels Laser derart ausgeführt wird, daß das Muster zusätzlich in der unter der elektrisch leitfähigen Schicht (4) liegenden Ionensperrschicht (2) erzeugt wird und Teile des Glassubstrats (1) freigelegt werden, und daß anschließend auf mindestens denjenigen Teilen des Substrats (1), die durch das Ritzen der elektrisch leitfähigen Schicht (4) mittels Laser freigelegt wurden, sowie auf der darunterliegenden Ionensperrschicht (2) eine zweite Ionensperrschicht (8) vorgesehen wird.

2. Verfahren nach Anspruch 1, wobei die zweite Ionensperrschicht (8) auf der gesamten Substratoberfläche ausgebildet wird.

3. Verfahren nach Anspruch 1 oder 2, wobei die zweite Ionensperrschicht (8) dadurch ausgebildet wird, daß auf die mit der elektrisch leitfähigen Schicht (4) bedeckte Oberfläche des Substrats (1) ein flüssiger Zwischenstoff aufgetragen wird, der in die durch das Ritzen mittels Laser erzeugten Nuten (6) eindringt, und der flüssige Zwischenstoff anschließend zur Ausbildung der zweiten Ionensperrschicht (8) gehärtet wird.

4. Verfahren nach einem der vorhergehenden Ansprüche, wobei Rückstände (5), die sich beim Ritzen mittels Laser auf der Oberfläche des Substrats (1) und der darüberliegenden elektrisch leitfähigen Schicht (4) ablagern, vor Ausbilden der zweiten Ionensperrschicht (8) entfernt werden.

5. Verfahren nach Anspruch 4, wobei die Rückstände (5) unter Verwendung eines Ätzmittels entfernt werden.

6. Verfahren nach einem der vorhergehenden Ansprüche, wobei das Ritzen mit einem Excimer-Laser durchgeführt wird.

7. Verfahren nach Anspruch 6, wobei die Wellenlänge der Laserstrahlung nicht größer ist als 400 nm.

8. Verfahren nach einem der vorhergehenden Ansprüche, wobei die elektrisch leitfähige Schicht (4) aus einem elektrisch leitfähigen transparenten Material gebildet wird.

9. Verfahren nach Anspruch 8, wobei das elektrisch leitfähige transparente Material Zinnoxid, Indiumoxid, Zinkoxid oder ITO enthält.

10. Verfahren nach einem der vorhergehenden Ansprüche, wobei die elektrisch leitfähige Schicht (4) eine Chrom- oder Molybdän-Dünnschicht umfaßt.

11. Verfahren nach einem der vorhergehenden Ansprüche, wobei die zweite Ionensperrschicht (8) aus einem als Orientierungs-Steuerschicht in einer Flüssigkristallanzeige geeigneten organischen Material gebildet wird.

12. Verfahren nach einem der vorhergehenden Ansprüche, wobei das Substrat (1) zur Verwendung in einer Flüssigkristall-Einrichtung bestimmt ist und die mittels Laser geritzten Muster Elektrodenbereiche der Flüssigkristall-Einrichtung definieren.

13. Verfahren nach einem der vorhergehenden Ansprüche, wobei das Substrat aus Natron-Kalk-Glas besteht.

14. Elektro-optische Einrichtung mit einer Flüssigkristall- oder einer Bildsensor-Einrichtung, umfassend ein Glassubstrat mit einer darauf ausgebildeten dünnen elektrisch leitfähigen Schicht, die ein mittels Laser geritztes Muster aufweist, wobei das Muster in der elektrisch leitfähigen Schicht durch ein Verfahren nach einem der vorhergehenden Ansprüche erzeugt ist.

## Revendications

1. Procédé de réalisation d'un motif dans une couche mince électriquement conductrice (4) formée sur un substrat de verre (1), avec interposition d'un film intercepteur d'ions (2), ledit procédé comprenant les étapes qui consistent :
- à former le film intercepteur d'ions (2) sur le substrat de serre (1), puis à former la couche électriquement conductrice (4) sur le dessus du film intercepteur d'ions (2) ; et
- à graver au laser la couche électriquement conductrice (4) de manière à former le motif désiré ;
le procédé étant caractérisé en ce que l'opération de gravure au laser est exécutée de telle façon que le motif soit formé additionnellement dans le film intercepteur d'ions (2) qui s'étend sous la couche électriquement conductrice (4) et que des parties du substrat de verre (1) soient mises à nu, et un second film intercepteur d'ions (8) est ensuite appliqué de manière à s'étendre sur au moins les parties du substrat (1) qui ont été mises à nu par l'opération de gravure au laser de la couche électriquement conductrice (4) et du film intercepteur d'ions sous-jacent (2).

2. Procédé tel que défini dans la revendication 1, selon lequel le second film intercepteur d'ions (8) est formé de façon à s'étendre sur la totalité de la surface du substrat.

3. Procédé tel que défini dans la revendication 1 ou 2, selon lequel on forme le second film intercepteur d'ions (8) en appliquant un matériau précurseur liquide sur la surface du substrat (1), revêtue de la couche électriquement conductrice (4), d'une façon telle que le matériau précurseur liquide pénètre dans les rainures (6) produites par l'opération de gravure au laser, et en soumettant ensuite le matériau précurseur liquide à une cuisson afin de former le second film intercepteur d'ions (8).

4. Procédé tel que défini dans l'une quelconque des revendications précédentes, selon lequel des résidus (5) qui se sont déposés sur la surface du substrat (1) et sur la couche électriquement conductrice (4) qui la recouvre, par suite de l'opération de gravure au laser, sont éliminés avant que le second film intercepteur d'ions (8) soit formé.

5. Procédé tel que défini dans la revendication 4, selon lequel les résidus (5) sont éliminés à l'aide d'un agent décapant.

6. Procédé tel que défini dans l'une quelconque des revendications précédentes, selon lequel l'opération de gravure au laser est mise en oeuvre à l'aide d'un laser excimer.

7. Procédé tel que défini dans la revendication 6, selon lequel la longueur d'onde du rayonnement émis par le laser n'est pas supérieure à 400 nm.

8. Procédé tel que défini dans l'une quelconque des revendications précédentes, selon lequel la couche électriquement conductrice (4) est réalisée en un matériau transparent électriquement conducteur.

9. Procédé tel que défini dans la revendication 8, selon lequel le matériau transparent électriquement conducteur comprend de l'oxyde d'étain, de l'oxyde d'indium, de l'oxyde de zinc ou de l'ITO.

10. Procédé tel que défini dans l'une quelconque des revendications précédentes, selon lequel la couche électriquement conductrice (4) comprend une couche mince de chrome ou de molybdène.

11. Procédé tel que défini dans l'une quelconque des revendications précédentes, selon lequel le second film intercepteur d'ions (8) est réalisé en un matériau organique adapté pour jouer le rôle d'un film de commande d'orientation dans un dispositif d'affichage à cristaux liquides.

12. Procédé tel que défini dans l'une quelconque des revendications précédentes, selon lequel le substrat (1) est destiné à être utilisé dans un dispositif à cristaux liquides et les motifs gravés au laser définissent les régions constituant les électrodes du dispositif à cristaux liquides.

13. Procédé tel que défini dans l'une quelconque des revendications précédentes, selon lequel le substrat est constitué de verre à base de chaux sodée.

14. Dispositif électro-optique comprenant un dispositif à cristaux liquides ou un capteur d'images, renfermant un substrat en verre ayant un motif formé, par gravure au laser, dans une couche mince électriquement conductrice présente sur le substrat, et dans lequel le motif est réalisé dans la couche électriquement conductrice selon le procédé défini dans l'une quelconque des revendications précédentes.
